Europäisches Patentamt

European Patent Office

Office européen des brevets

(11) Veröffentlichungsnummer : **0 070 503**
**B1**

(12) **EUROPÄISCHE PATENTSCHRIFT**

(45) Veröffentlichungstag der Patentschriff :
22.10.86

(51) Int. Cl.⁴ : **H 03 H 9/05**

(21) Anmeldenummer : **82106267.6**

(22) Anmeldetag : **13.07.82**

(54) **Halte- und Anschlussvorrichtung für einen scheibenförmigen piezoelektrischen Resonator.**

(30) Priorität : **16.07.81 DEU 8120939**

(43) Veröffentlichungstag der Anmeldung :
**26.01.83 Patentblatt 83/04**

(45) Bekanntmachung des Hinweises auf die Patenterteilung : **22.10.86 Patentblatt 86/43**

(84) Benannte Vertragsstaaten :
**CH DE FR GB IT LI**

(56) Entgegenhaltungen :
**DE-A- 1 541 640**
**FR-A- 1 003 370**
**GB-A- 608 986**
**GB-A- 998 029**

(73) Patentinhaber : **Siemens Aktiengesellschaft Berlin und München**
**Wittelsbacherplatz 2**
**D-8000 München 2 (DE)**

(72) Erfinder : **Kreutzer, Hans, Dipl.-Ing.**
**Ostmarkstrasse 20**
**D-8000 München 70 (DE)**
Erfinder : **Mattuschka, Werner, Ing.-Grad.**
**Johann-Clanze-Strasse 21**
**D-8000 München 70 (DE)**

## Beschreibung

Die Erfindung bezieht sich auf eine Halte- und Anschlußvorrichtung für einen scheibenförmigen, piezoelektrischen Resonator, der beidseitig mit Anregungselektroden versehen ist, deren Durchmesser geringer als der Durchmesser des Resonators ist und die auf jeder Seite des Resonators eine bis zum Rand des Resonators reichende Anschlußelektrode aufweisen, die mit der Anregungselektrode verbunden ist und zur jeweils anderen Anschlußelektrode entgegengesetzt gerichtet ist, mit zwei jeweils aus einem Abschnitt eines Federblechstreifens gebildeten Halteorganen, welche mit ihrem vom Resonator abgewandten Ende an Kontaktstiften befestigt sind, die eine Bodenplatte durchdringen, und an ihrem resonatorseitigen Ende mit jeweils einem Paar von quer zum Verlauf des Halteorgans gerichteten Zungen versehen sind, die durch wurzelseitiges Abwinkeln einander gegenüberliegend angeordnet sind und jeweils einen Randabschnitt des Resonators im Bereich der Anschlußelektroden zwischen sich aufnehmen.

Eine solche Anschluß- und Haltevorrichtung ist aus dem DE-GM 18 44 637 bekannt. Der Resonator wird dabei mit Randabschnitten so zwischen Klipse eingeschoben, die von den Zungenpaaren der Halteorgane gebildet werden, daß die gegeneinander federnden Zungen eines jeden Zungenpaares den Rand des Resonators federnd einklemmen. Durch Einbringen eines leitenden Kittes zwischen Resonator und Halteorgan-Zungen wird zusätzlich zur Klemmhalterung des Resonators auch noch eine Klebeverbindung zwischen den Halteorganen und dem Resonator erzeugt. Zugleich werden auf diese Weise die mit den Anregungselektroden zusammenhängenden Anschlußelektroden an eine Wechselspannungsquelle angeschlossen. In Richtung zur Bodenplatte bzw. entgegengesetzt hierzu wird der Resonator bei einer solchen Halte- und Anschlußvorrichtung jedoch nur durch die Klemmwirkung der Zungen und die Klebeverbindung zwischen den Zungen und dem Resonator festgehalten, wobei außerdem die Haltewirkung der Anschlußelektroden am Resonator eine Rolle spielt. Wird eine solche Resonatorhalterung stärkeren Erschütterungen, z. B. Stößen oder Vibrationen ausgesetzt, so kann es zu einer Ablösung der Anschlußelektroden vom Resonator bzw. zu einer Unterbrechung der Anschlußelektroden kommen.

Aufgabe der Erfindung ist es daher, eine Vorrichtung der eingangs genannten Art so auszubilden, daß der Resonator in allen Richtungen durch Formschlußkonturen in seiner vorgesehenen Position festgehalten wird, und daß die Montage des Resonators, also die Verbindung des Resonators mit den Halteorganen, dennoch relativ unkompliziert vorgenommen werden kann.

Erfindungsgemäß ergibt sich die Lösung dieser Aufgabe dadurch, daß die beiden Halteorgane am resonatorseitigen Ende mit aufeinanderzuweisenden abgewinkelten Endabschnitten versehen sind, daß der Resonator im Bereich seiner Anschlußelektroden radial gerichtete Einschnitte zur Aufnahme der abgewinkelten Endabschnitte der Halteorgane aufweist, und daß die Zungen am abgewinkelten Endabschnitt der Halteorgane angesetzt sind.

Auf diese Weise wird eine Anschluß- und Haltevorrichtung für eine scheibenförmigen Resonator geschaffen, die den Resonator in allen Richtungen rüttelsicher festhält.

In weiterer Ausgestaltung der Erfindung ist vorgesehen, daß die freien Enden der Zungen von der Bodenplatte abgewandt vorgesehen sind.

Vorteilhaft bilden die Zungen auf diese Weise nach oben offene, also leicht zugängliche Taschen zur Aufnahme eines Leitklebers oder leitenden Kittes, der insbesondere die elektrische Verbindung zwischen den Halteorganen und den Anschlußelektroden des Resonators verbessert.

Im Rahmen der Erfindung kann ferner vorgesehen sein, daß die Zungen mit je einer zentralen kalottenförmigen Ausprägung, die gegen den Resonator gerichtet ist, versehen sind, und daß die Ausprägungen in ihrem Scheitelbereich wenigstens einen Durchbruch aufweisen, und daß die abgewinkelten Endabschnitte der Halteorgane innerhalb der Resonator-Einschnitte mit wenigstens einem Durchbruch versehen sind.

Dadurch werden vorteilhaft Durchtrittsöffnungen für den Leitkleber oder leitenden Kitt geschaffen, so daß dieser an alle Stellen vordringen kann, die für die Ausbildung einer guten Verbindung zwischen den Halteorganen und den Anschlußelektroden des Resonators wichtig sind.

Nachfolgend wird ein Ausführungsbeispiel der Erfindung anhand von vier Figuren noch näher erläutert.

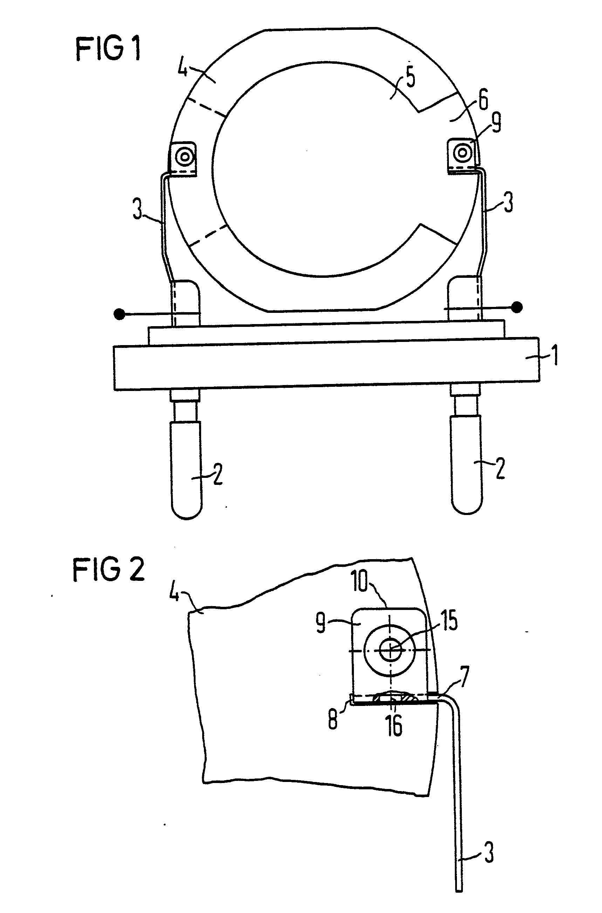

Dabei zeigen, jeweils stark vergrößert, Figur 1  in Seitenansicht, den mit den Halteorganen verbundenen Resonator,

Figur 2  das Ineinandergreifen von Halteorgan und Resonator, und

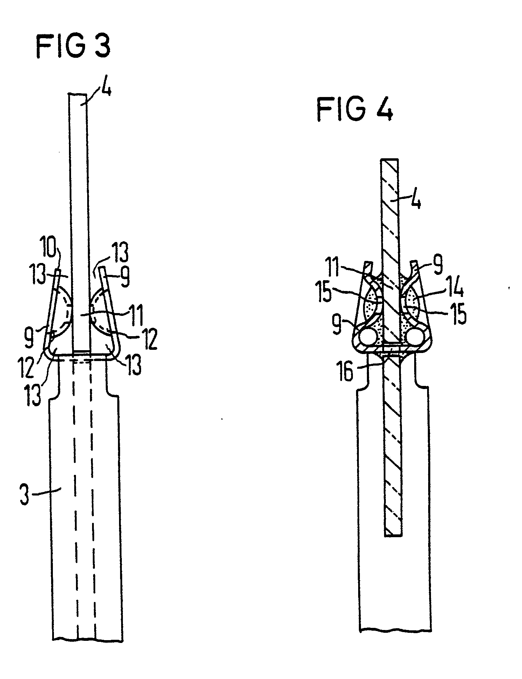

Figur 3 und 4  Resonator und Halteorgan in Richtung der grossen Oberflächen des Resonators gesehen.

Im einzelnen ist den Figuren zu entnehmen, daß eine Bodenplatte 1 eines Resonatorgehäuses von zwei Anschlußstiften 2 durchdrungen wird. Auf der Resonatorseite der Bodenplatte 1 sind aus einem Abschnitt eines Federblechstreifens bestehende Halteorgane 3 mit den aus der Bodenplatte vorstehenden Enden der Anschlußstifte 2 verbunden, z. B. verschweißt. Die Halteorgane 3 verlaufen im wesentlichen in der gleichen Richtung wie die Anschlußstifte 2 und stehen sich mit ihren Flachseiten einander gegenüber. Dabei ist der Abstand der beiden Halteorgane 3 voneinander so bemessen, daß er etwa dem Durchmesser eines kreisscheibenförmigen Resonators 4 entspricht, der von den Halteorganen fixiert werden soll.

Auf seinen beiden großen Oberflächen ist der Resonator 4 mit je einer zentralen Anregungselektrode 5 versehen. Die Anregungselektrode reicht nicht bis zum Rand des Resonators, so daß entlang des Randes ein elektrodenfreier Streifen vorhanden ist. Lediglich in einem bestimmten Randabschnitt ist auf jeder Seite des Resonators eine Anschlußelektrode 6 vorgesehen, die mit der Anregungselektrode auf derselben Seite des Resonators zusammenhängt und bis zum Rand des Resonators reicht. Da die Anschlußelektrode 6 auf der einen Seite des Resonators zu der Anschlußelektrode auf der anderen Seite des Resonators entgegengesetzt gerichtet ist, liegt den Anschlußelektroden jeweils ein elektrodenfreier Randabschnitt auf der anderen Seite des Resonators gegenüber.

Die Halteorgane 3 sind an ihrem resonatorseitigen Ende mit einem abgewinkelten Endabschnitt 7 versehen, der so bemessen ist, daß er in einen radial gerichteten Einschnitt 8 im Resonator 4 eingefügt werden kann. Die Einschnitte 8 sind im Bereich der Anschlußelektroden 6 vorgesehen und liegen auf demselben Durchmesser. Zum Einsetzen des Resonators 4 in die Anschluß- und Haltevorrichtung müssen die Anschlußorgane 3 etwas auseinandergespreizt werden, bis die Endabschnitte 7 in die Einschnitte 8 eindringen können. Quer zum Verlauf der Halteorgane 3 und im Bereich der Endabschnitte 7 vorgesehene, einstückig mit den Halteorganen 3 zusammenhängende Zungenpaare 9 sind gegen die Endabschnitte 7 der Halteorgane 3 so abgewinkelt, daß sie mit ihren freien Enden 10 nach oben weisen, also von der Bodenplatte 1 weggerichtet sind. Die beiden Zungen 9 eines jeden Halteorganes 3 bilden auf diese Weise Klipse, die einen Randabschnitt 11 des Resonators zwischen sich aufnehmen.

Die Zungen 9 weisen kalottenförmige Ausprägungen 12 auf, die zum Resonator 4 hin gerichtet sind. Mit diesen Ausprägungen 12 stützen sich die Zungen 9 am Resonator 4 ab. Die Zungen 9 bilden auf diese Weise nach oben offene Taschen 13, in die unschwierig Leitkleber 14 eingebracht werden kann.

Damit der Leitkleber 14 ungehindert an alle Stellen gelangen kann, die von dem Kleber benetzt werden sollen, ist im Scheitelbereich der Ausprägungen 12 jeweils ein Durchbruch 15 vorgesehen. Zum gleichen Zweck ist in jedem Endabschnitt 7 im Bereich zwischen den Zungen 9 ein weiterer Durchbruch 16 vorgesehen.

Insgesamt ergibt sich auf diese Weise eine rüttelsichere Verbindung zwischen den Halteorganen 3 und dem Resonator 4, wobei zugleich eine gute elektrische Verbindung zwischen den Anregungselektroden 5 und den Anschlußstiften 2 geschaffen wird.

Liste der Bezugszeichen

1 Bodenplatte
2 Anschlußstift
3 Halteorgan
4 Resonator
5 Anregungselektrode
6 Anschlußelektrode
7 Halteorgan-Endabschnitt .
8 Resonator-Einschnitt
9 Halteorgan-Zunge
10 freies Zungenende
11 Resonator-Randabschnitt
12 kalottenförmige Ausprägung
13 Taschen
14 Leitkleber
15 Durchbruch in Ausprägung
16 Durchbruch in Endabschnitt

**Patentansprüche**

1. Halte- und Anschlußvorrichtung für einen scheibenförmigen piezoelektrischen Resonator (4), der beidseitig mit Anregungselektroden (5) versehen ist, deren Durchmesser geringer als der Durchmesser des Resonators ist und die auf jeder Seite des Resonators eine bis zum Rand des Resonators reichende Anschlußelektrode (6) aufweisen, die mit der Anregungselektrode (5) verbunden ist und zur jeweils anderen Anschlußelektrode entgegengesetzt gerichtet ist, mit zwei jeweils aus einem Abschnitt eines Federblechstreifens gebildeten Halteorganen (3), welche mit ihrem vom Resonator abgewandten Ende an Kontaktstiften (2) befestigt sind, die eine Bodenplatte (1) durchdringen, und an ihrem resonatorseitigen Ende mit jeweils einem Paar von quer zum Verlauf des Halteorgans (3) gerichteten Zungen (9) versehen sind, die durch wurzelseitiges Abwinkeln einander gegenüberliegend angeornet sind und jeweils einen Randabschnitt (11) des Resonators im Bereich der Anschlußelektroden (6) zwischen sich aufnehmen, dadurch gekennzeichnet, daß die beiden Halteorgane (3) am resonatorseitigen Ende mit aufeinanderzuweisenden abgewinkelten Endabschnitten (7) versehen sind, daß der Resonator (4) im Bereich seiner Anschlußelektroden (6) radial gerichtete Einschnitte (8) zur Aufnahme der abgewinkelten Endabschnitte (7) der Halteorgane (3) aufweist, und daß die Zungen (9) am abgewinkelten Endabschnitt (7) der Halteorgane (3) angesetzt sind.

2. Vorrichtung nach Anspruch 1, dadurch gekennzeichnet, daß die freien Enden (10) der Zungen (9) von der Bodenplatte (1) abgewandt vorgesehen sind.

3. Haltevorrichtung nach Anspruch 2, dadurch gekennzeichnet, daß die Zungen (9) mit je einer zentralen kalottenförmigen Ausprägung (12), die gegen den Resonator (4) gerichtet ist, versehen sind und daß die Ausprägungen (12) in ihrem Scheitelbereich wenigstens einen Durchbruch (15) aufweisen.

4. Vorrichtung nach Anspruch 3, dadurch gekennzeichnet, daß die abgewinkelten Endabschnitte (7) der Halteorgane (3) innerhalb der Resonator-Einschnitte (8) mit wenigstens einem Durchbruch (16) versehen sind.

## Claims

1. A holding and connecting device for a disc-shaped piezoelektric resonator (4) which is provided with excitation electrodes (5) on both sides, whose diameter is smaller than the diameter of the resonator, and which on each side of the resonator has a connecting electrode (6) extending to the edge of the resonator which is connected to the excitation electrode (5) and is oppositely directed to the respective other connecting electrode, said device comprising two holding elements (3) which are respectively formed from a section of a resilient metal strip, and have their ends facing away from the resonator secured to contact pins (2) which pass through a base plate (1) and which at their ends on the resonator side are in each case provided with a pair of tongues (9) which are aligned transversely to the course of the holding element (3) and which are arranged so as to face one another by bending at the root end, and which in each case accommodate between them an edge section (11) of the resonator in the region of the connecting electrode (5), characterised in that at the ends on the resonator side, the two holding elements (3) are provided with angled end sections (7) which point to one another ; that in the region of its connecting electrodes (6), the resonator (4) has radially directed notches (8) to house the angled end sections (7) of the holding elements (3) ; and that the tongues (9) are fastened to the angled end sections (7) of the holding elements (3).

2. A device as claimed in Claim 1, characterised in that the exposed ends (10) ot the tongues (9) are arranged so as to face away from the base plate (1).

3. A holding device as claimed in Claim 2, characterised in that the tongues (9) are in each case provided with a central spherical protuberance (12) which is directed towards the resonator (4), and that the protuberances (12) have at least one opening (15) in their apical region.

4. A device as claimed in Claim 3, characterised in that the angled end section (7) of the holding elements (3) are provided with at least one opening (16) within the resonator notches (8).

## Revendications

1. Dispositif de maintien et de raccordement pour un résonateur piézo-électrique discoïde (4), qui est muni, des deux côtés, d'électrodes d'excitation (5) dont le diamètre est inférieur au diamètre du résonateur et qui présente, sur chaque côté du résonateur, une électrode de raccordement (6) s'étendant jusqu'au bord du résonateur, qui est reliée à l'électrode d'excitation (5) et est dirigée en sens contraire à l'autre électrode de raccordement, dispositif comprenant deux organes de maintien (3), formés chacun d'un morceau de bande de tôle à ressort et fixés par leur extrémité éloignée du résonateur à des broches de connexion (2), lesquelles traversent une plaque de base (1) et sont munies chacune à leur extrémité côté résonateur, d'une paire de languettes (9) orientées transversalement à l'étendue de l'organe de maintien (3), qui sont disposées l'une en face de l'autre par repliage côté racine et reçoivent entre elles une portion du bord (11) du résonateur dans la région des électrodes de raccordement (6), caractérisé en ce que les deux organes de maintien (3) sont munis de portions terminales coudées (7) dirigées l'une vers l'autre à l'extrémité côté résonateur, que le résonateur (4) présente des entailles (8) orientées radialement pour la réception des portions terminales coudées (7) des organes de maintien (3) dans la région de ses électrodes de raccordement (6), et que les languettes (9) sont disposées sur la portion terminale coudée (7) des organes de maintien (3).

2. Dispositif selon la revendication 1, caractérisé en ce que les extrémités libres (10) des languettes (9) sont disposées éloignées de la plaque de base (1).

3. Dispositif selon la revendication 2, caractérisé en ce que les languettes (9) sont chacune pourvues d'une déformation constituant une protubérance centrale (12) en forme de calotte sphérique, qui est dirigée vers le résonateur (4), et que les protubérances (12) présentent au moins une ouverture (15) dans la région de leur sommet.

4. Dispositif selon la revendication 3, caractérisé en ce que les portions terminales coudées (7) des organes de maintien (3) sont pourvues d'au moins une ouverture (16) à l'intérieur des entailles (8) du résonateur.

FIG 1

4

5

6

9

3

3

1

2

2

FIG 2

4

10

9

15

7

8

16

3

## FIG 3

4

10
13
13
9
12
12
13
13

11

9

12

13

3

## FIG 4

4

11
9
15
14
9
15
9

16